# EUROPÄISCHE PATENTANMELDUNG

(11) **EP 3 672 078 A1**
(43) Veröffentlichungstag der Anmeldung: **24.06.2020**
(21) Anmeldenummer: 18213350.4
(22) Anmeldetag: 18.12.2018
(51) Int. Cl.: H03K 17/0812, H03K 17/0412

(54) **VERFAHREN ZUM ANSTEUERN VON HALBLEITERN**

(71) Anmelder: Siemens Aktiengesellschaft, 80333 München (DE)
(72) Erfinder: Ditterich, Jürgen, 90427 Nürnberg (DE); Eder, Herbert, 90610 Winkelhaid (DE)

(57) **Zusammenfassung**

Die Erfindung betrifft ein Verfahren zum Ansteuern einer Vielzahl von Halbleitern (1) durch eine Regelungseinheit (2), wobei zwischen der Regelungseinheit (2) und den Halbleitern (1) eine Signalleitung (3) angeordnet ist, wobei über die Signalleitung (3) ein Protokoll (11) zur Ansteuerung der Halbleiter (1) übertragen wird. Zur Verbesserung der Übertragung von Signalen von der Regelungseinheit zum Stromrichter hinsichtlich der Übertragungssicherheit wird vorgeschlagen, dass über die Signalleitung (3) zusätzlich ein Lebendsignal (12) übertragen wird, wobei bei Ausbleiben des Lebendsignals (12) die Halbleiter (1) abgeschaltet werden. Weiter betrifft die Erfindung eine Halbleiterschaltung (5), aufweisend eine Vielzahl von Halbleitern (1) mit jeweils einer Treiberschaltung (4) und eine Regelungseinheit (2), wobei zwischen der Regelungseinheit (2) und den Halbleitern (1) eine Signalleitung (3) angeordnet ist, wobei über die Signalleitung (3) ein Protokoll (11) zur Ansteuerung der Halbleiter (1) übertragbar ist, wobei über die Signalleitung (3) zusätzlich ein Lebendsignal (12) übertragbar ist, wobei bei Ausbleiben des Lebendsignals (12) die Halbleiter (1) mittels der jeweiligen Treiberschaltung (4) abschaltbar sind. Die Erfindung betrifft ferner einen Stromrichter (20) mit einer derartigen Halbleiterschaltung (5), wobei die Halbleiter (1) oder zumindest ein Teil der Halbleiter (1) in einer Brückenschaltung angeordnet sind. Die Erfindung betrifft weiter ein Fahrzeug (30) sowie eine Windenergieanlage (40) mit einem derartigen Stromrichter (20).

## Beschreibung

Die Erfindung betrifft ein Verfahren zum Ansteuern einer Vielzahl von Halbleitern durch eine Regelungseinheit, wobei zwischen der Regelungseinheit und den Halbleitern eine Signalleitung angeordnet ist, wobei über die Signalleitung ein Protokoll zur Ansteuerung der Halbleiter übertragen wird. Ferner betrifft die Erfindung eine Halbleiterschaltung mit einer Vielzahl von Halbleitern mit jeweils einer Treiberschaltung und einer Regelungseinheit, wobei zwischen der Regelungseinheit und den Halbleitern eine Signalleitung angeordnet ist, wobei über die Signalleitung ein Protokoll zur Ansteuerung der Halbleiter übertragbar ist. Die Erfindung betrifft weiter einen Stromrichter mit einer derartigen Halbleiterschaltung. Weiter betrifft die Erfindung ein Fahrzeug mit einem derartigen Stromrichter sowie eine Windenergieanlage mit einem derartigen Stromrichter.

Um den Verdrahtungsaufwand innerhalb einer Halbleiterschaltung oder eines Stromrichters zu optimieren, wird zwischen der Regelungseinheit und den Halbleitern von einem parallelen Ansteuerverfahren auf ein serielles Ansteuerverfahren gewechselt. Während das parallele Ansteuerverfahren für jeden anzusteuernden Halbleiter jeweils eine Einzelansteuerleitung benötigt wird, werden diese Informationen bei dem seriellen Ansteuerverfahren auf nur einer Leitung gebündelt und mittels eines Protokolls, auch als Telegramm bezeichnet, übertragen. Die Halbleiter weisen dabei jeweils eine Treiberschaltung auf, die das für sie betreffende Signal, insbesondere bezüglich der Ansteuerung, d.h. Einschalten oder Ausschalten, auswertet und am Halbleiter umsetzt.

Der Erfindung liegt die Aufgabe zugrunde, die Übertragung von Signalen von der Regelungseinheit zum Stromrichter hinsichtlich der Übertragungssicherheit zu verbessern.

Diese Aufgabe wird durch ein Verfahren zum Ansteuern einer Vielzahl von Halbleitern durch eine Regelungseinheit dadurch gelöst, dass zwischen der Regelungseinheit und den Halbleitern eine Signalleitung angeordnet ist, wobei über die Signalleitung ein Protokoll zur Ansteuerung der Halbleiter übertragen wird, wobei über die Signalleitung zusätzlich ein Lebendsignal übertragen wird, wobei bei Ausbleiben des Lebendsignals die Halbleiter abgeschaltet werden. Ferner wird diese Aufgabe durch eine Halbleiterschaltung, aufweisend eine Vielzahl von Halbleitern mit jeweils einer Treiberschaltung und eine Regelungseinheit dadurch gelöst, dass zwischen der Regelungseinheit und den Halbleitern eine Signalleitung angeordnet ist, wobei über die Signalleitung ein Protokoll zur Ansteuerung der Halbleiter übertragbar ist, wobei über die Signalleitung zusätzlich ein Lebendsignal übertragbar ist, wobei bei Ausbleiben des Lebendsignals die Halbleiter mittels der jeweiligen Treiberschaltung abschaltbar sind. Diese Aufgabe wird weiter durch einen Stromrichter mit einer derartigen Halbleiterschaltung dadurch gelöst, dass die Halbleiter oder zumindest ein Teil der Halbleiter in einer Brückenschaltung angeordnet sind. Ferner wird diese Aufgabe durch ein Fahrzeug mit einem derartigen Stromrichter sowie durch eine Windenergieanlage mit einem derartigen Stromrichter gelöst.

Weitere vorteilhafte Ausgestaltungen der Erfindung sind in den abhängigen Ansprüchen angegeben.

Der Erfindung liegt die Erkenntnis zugrunde, dass sich die Übertragungssicherheit dadurch verbessern lässt, wenn ein Ausfall oder eine Störung der Signalübertragung der Signalübertragung zuverlässig und schnell erkannt wird. Üblicherweise wird eine Störung dann erkannt, wenn das Protokoll bzw. Telegramm ausgewertet wird. Dabei kann das Protokoll derart aufgebaut sein, Fehler in der Übertragung zu erkennen. Ein Beispiel für ein derartiges Telegramm ist eine CRC Kodierung. Durch die Verwendung von Telegrammen entstehen allerdings zur Bildung der Schaltinformation in der Halbleiterschaltung bzw. im Stromrichter Verzugszeiten, die eben auch auf ggf. erforderliche Schutzabschaltungen (detektiert und ausgeführt durch die Regelungseinheit) wirken. Dadurch ist ein ausreichendes Schutzkonzept des Umrichters nicht mehr gewährleistet, da Schutzabschaltzeiten zwischen ein und zwei Telegrammlängen entstehen. Die Fehlererkennungszeit bzw. die Anforderung zur Abschaltung der Halbleiter durch die Regelungseinheit als Schutzeingriff liegt damit in der Größenordnung von 5 µs bis 10 µs. In dieser Zeit können bereits Ströme in der Halbleiterschaltung bzw. im Stromrichter entstehen, die zur Beschädigung oder Zerstörung des Halbleiters bzw. Stromrichters führen.

Zur Lösung dieses Problems wird daher den seriellen Telegrammen zur Ansteuerung der Halbleiter auf derselben Signalleitung durch die Regelungseinheit ein Lebendsignal überlagert. Dies wird auf der Treiberschaltung des Halbleiters permanent auf Ausbleiben überwacht. Wenn es nicht mehr vorhanden ist, erfolgt ein Abschalten der Halbleiter durch die Treiberschaltung. Dabei kann es sich um einen Schutzeingriff oder ein betrieblich gewolltes schnelles Abschalten der Halbleiter handeln.

Ein von der Regelungseinheit zu initiierender Schutzeingriff wirkt ebenfalls direkt auf das Lebendsignal. Das Lebendsignal wird dann nicht mehr über die Signalleitung übertragen. Dies erkennt die Treiberschaltung des Halbleiters, so dass die Halbleiter unmittelbar abgeschaltet werden. Damit sind schnelle Schutzreaktionszeiten realisierbar, die mit denen der Einzelansteuerung vergleichbar sind. Der Anteil an Fehlerreaktionszeit durch die Kommunikation zwischen Regelungseinheit und Treiberschaltung wird damit auf die Größenordnung von 200 ns reduziert, mit der ein zuverlässiger Schutz der Halbleiterschaltung bzw. des Stromrichters sichergestellt werden kann.

Auf diese Weise ist es möglich, Signale zur Ansteuerung der Halbleiter auf einer Signalleitung zu bündeln und gleichzeitig einen schnellen Schutz zu realisieren. Der Schutzeingriff ergibt sich dabei direkt von der Regelungseinheit initiiert, durch abschalten des Lebendsignals oder durch einen Fehler in der Übertragung, beispielsweise durch Kabelbruch der Signalleitung.

Bei einer vorteilhaften Ausgestaltung der Erfindung wird das Lebendsignal zyklisch oder dauerhaft übertragen. Damit der Empfänger, also der Halbleiter, genau weiß, wann ein Lebendsignal zu erwarten ist, um bei Ausbleiben eine Schutzabschaltung zu erwirken, ist es vorteilhaft, wenn das Lebendsignal zyklisch oder dauerhaft übertragen wird. Damit sind die Zeitpunkte, an denen ein Lebendsignal von der Treiberschaltung erwartet wird, bekannt und eine Schutzabschaltung kann besonders schnell erfolgen.

Bei einer weiteren vorteilhaften Ausgestaltung der Erfindung wird das Lebendsignal als Manchester Code übertragen. Der Manchester-Code ist eine besonders einfache Kodierung, mit der ein Lebendsignal auf einer Signalleitung generiert werden kann. Entsprechende Baugruppen sind günstig am Markt verfügbar, so dass der Gewinn durch die Reduktion der Hardwareverdrahtung nur unwesentlich durch die Baugruppen zur Generierung des Manchester-Codes verringert wird. Somit kann eine Kostenreduktion bei der Herstellung der Halbleiterschaltung bzw. des Stromrichters erzielt werden. In einer vorteilhaften Ausgestaltung kann die Manchester-Codierung auch in die Hardware der Regelungseinheit und der Treiberschaltung oder eines Umsetzers integriert werden.

Bei einer weiteren vorteilhaften Ausgestaltung der Erfindung ist die Signalleitung als Lichtwellenleiter oder Bussystem ausgebildet. Sowohl Lichtwellenleiter als auch Bussystem stellen einfache und am Markt befindliche Lösungen zur Bündelung von Signalen dar. Diese können auf einfache Weise in die Halbleiterschaltung bzw. den Stromrichter integriert werden. Darüber hinaus bietet der Lichtwellenleiter zusätzlich noch den Vorteil der Potentialtrennung. Diese ist gerade für die Halbleiterschaltung bzw. Stromrichter mit einer Zwischenkreisspannung von mindestens 1500 V von Vorteil. Durch die Verwendung des Lichtwellenleiters ist eine Potentialverschleppung ausgeschlossen. Es wird zuverlässig verhindert, dass damit die Regelungseinheit mit unzulässig hohen Spannungen beaufschlagt wird. Da die Regelungsbaugruppe oftmals mit Bedienelementen elektrisch verbunden ist, wird damit auch die Beaufschlagung von unzulässig hohen Spannungen auf das Bedienelement verhindert und ein hinreichender Berührschutz sichergestellt. Dieser Berührschutz dient zur Vermeidung von Personenschäden.

Im Folgenden wird die Erfindung anhand der in den Figuren dargestellten Ausführungsbeispiele näher beschreiben und erläutert. Es zeigen:
- FIG 1: den Aufbau der Halbleiterschaltung,
- FIG 2: die zeitliche Reaktion bei der Übertragung eines Schutzeingriffs ohne Lebendsignal,
- FIG 3: die zeitliche Reaktion bei der Übertragung eines Schutzeingriffs mit Lebendsignal,
- FIG 4: ein Fahrzeug mit einer derartigen Halbleiterschaltung und
- FIG 5: eine Windenergieanlage mit einer derartigen Halbleiterschaltung.

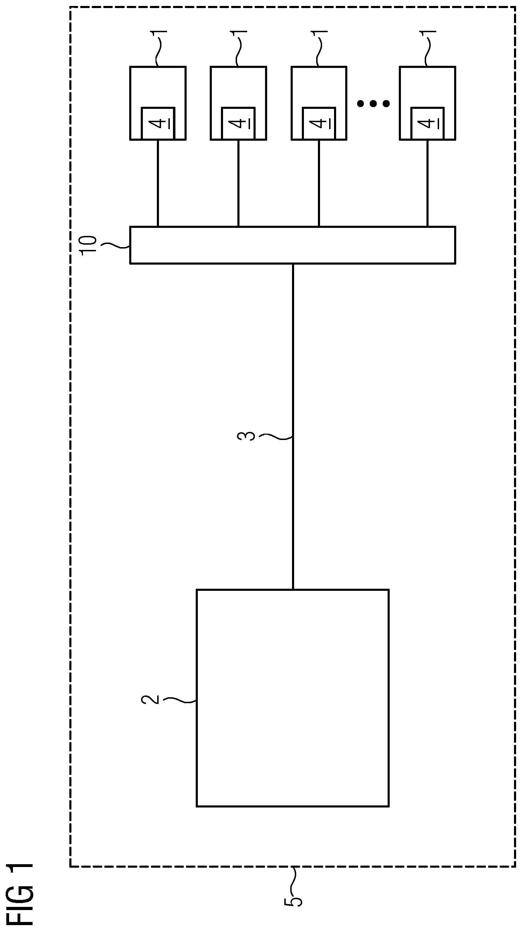

Die FIG 1 zeigt den Aufbau einer Halbleiterschaltung 5. Diese weist eine Regelungseinheit 2 und eine Vielzahl von Halbleitern 1 auf. Die Regelungseinheit 2 ist über eine Signalleitung 3 mit den Halbleitern 1 verbunden. Über die Signalleitung 3 werden Ansteuersignale 13, d.h. Schaltinformationen für die einzelnen Halbleiter 1, an die Halbleiter 1 übertragen. Diese Signale werden in einer Treiberschaltung 4 aufgenommen und in Ansteuerimpulse für das schaltende Element des Halbleiters 1 umgesetzt. Die Ansteuersignale 13 werden, um eine separate Leitung für jeden Halbleiter 1 zu vermeiden, gebündelt in einem Protokoll 11 über nur eine Signalleitung 3 übertragen. Die Darstellung der Ansteuersignale 13 und des Protokolls 11 erfolgt mit den Bezugszeichen in den folgenden Figuren. Bei der Signalleitung 3 kann es sich beispielsweise um eine Lichtwellenleitung oder eine Kupferleitung handeln. Bei einer Kupferleitung ist vorteilhafterweise jeweils ein Leitungspaar vorzusehen, damit Hin- und Rückstrom fließen können, bzw. eine definierte Spannung zwischen den beiden Potentialen des Leitungspaares anliegt. Um die Signale, d.h. das Protokoll 11, auf die einzelnen Halbleiter 1 aufzuteilen, ist, vorzugsweise in räumlicher Nähe zu den Halbleitern 1, ein Umsetzer 10 vorhanden. Dieser kann auch beispielsweise ein optisches Signal in ein elektrisches Signal umsetzen. Ebenso kann, allerdings nicht notwendigerweise, auch schon eine Auswertung des Protokolls 11 zumindest teilweise im Umsetzer 10 erfolgen.

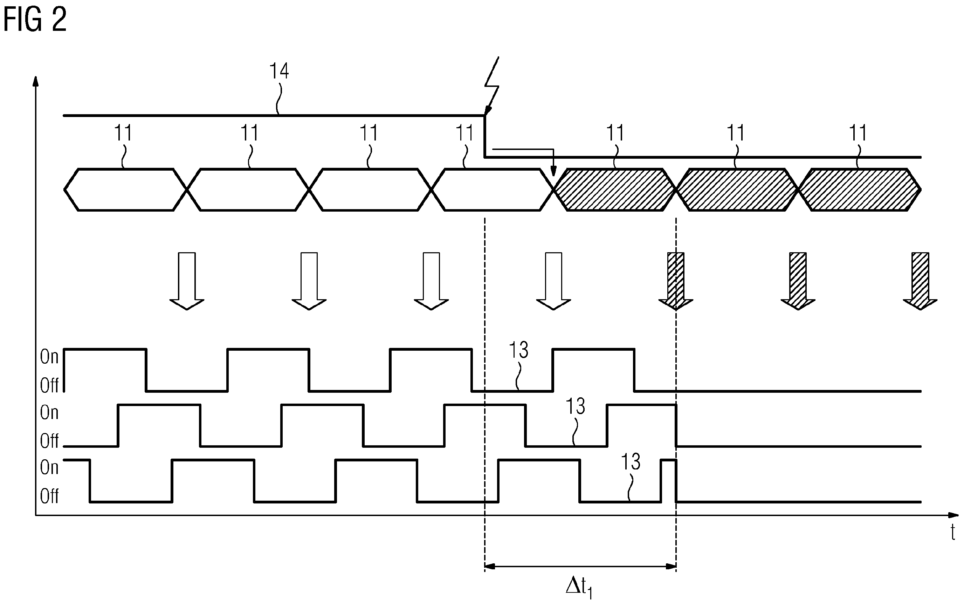

Die FIG 2 zeigt den zeitlichen Verlauf der Wirkung der Signalübertragung von der Regelungseinheit 2 zu den Halbleitern 1. Solange das Betriebssignal 14 anliegt, in diesem Beispiel als ein High Pegel dargestellt, sendet die Regelungseinheit 2 Protokolle 11 mit der Information zu den Schalthandlungen über die Signalleitung 3 an die Treiberschaltung 4 der Halbleiter 1. Die Treiberschaltung 4 wertet diese aus und wandelt diese in Ansteuersignale 13 für das schaltende Element der jeweiligen Halbleiter 1, in diesem Fall drei Halbleiter 1, um. Sollen nun die Halbleiter 1 zum Zeitpunkt, der mit dem Blitz gekennzeichnet ist, alle abgeschaltet werden, sei es aus einer betrieblichen Anforderung oder aufgrund einer Schutzreaktion, so wird diese Information in das Protokoll 11 aufgenommen. Diese Protokolle 11 sind dunkel gekennzeichnet. Es kann allerdings erst in das erste Protokoll 11 vollständig aufgenommen werden, dass der Anforderung zur Abschaltung folgt. Erst nach der Auswertung des entsprechenden Protokolls durch die Treiberschaltung kann diese Information an die Ansteuersignale 13 für die schaltenden Elemente der Halbleiter 1 ausgeführt werden. Damit ergibt sich für die Abschaltung der Halbleiter 1, insbesondere für eine entsprechende Schutzreaktion, eine Zeitdauer Δt₁ von Beginn der Abschaltung bis zur Ausführung. Diese liegt in der Größenordnung von bis zu zwei Protokolllängen und entspricht üblicherweise eine Zeitdauer von 5µs bis 10µs.

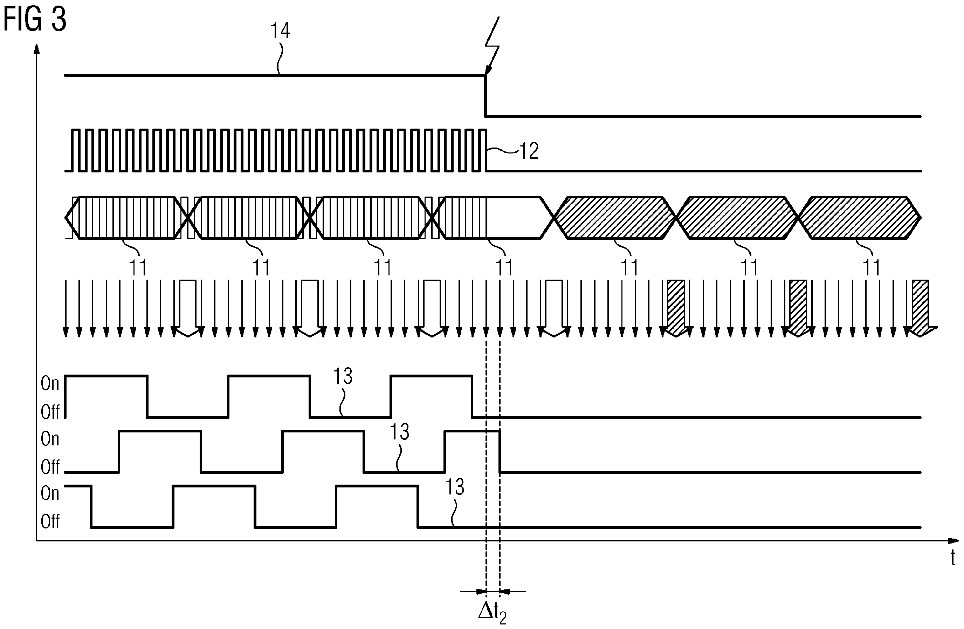

Die FIG 3 zeigt einen ähnlichen Verlauf, der sich bei der Verwendung eines Lebendsignals 12 ergibt. Zur Vermeidung von Wiederholungen wird auf die Beschreibung zur FIG 2 sowie auf die dort eingeführten Bezugszeichen verwiesen. Auch hier kennzeichnet das Betriebssignal 14 den Zeitpunkt zur Anforderung zum Abschalten der Halbleiter 1. Zu diesem Zeitpunkt wird das Lebendsignal 12 abgeschaltet. Das Lebendsignal ist, wie durch das Rechtecksignal dargestellt, Teil des Protokolls 11. Die Protokolle 11 werden nicht nur nach vollständiger Übertragung ausgewertet, wie durch die dicken Pfeile dargestellt, sondern kontinuierlich oder in kurzen Zeitabständen von weniger als 1µs, besonders vorteilhaft in der Größenordnung von 100ns, auf das Vorhandensein des Lebendsignals 12 hin überprüft. Sobald es nicht mehr im Protokoll vorhanden ist, d.h. bei Ausbleiben des Lebendsignals, werden die Halbleiter 1 direkt abgeschaltet. Dies führt zu einer Reaktionszeit Δt₂, die in der Größenordnung der Zeitabstände bei der Überprüfung des Lebendsignals liegt. Um eine besonders sichere und zuverlässige Abschaltung zu gewährleisten, kann auch erst bei Ausbleiben zweier oder allgemein einer vorher festgelegten Anzahl von Schaltflanken abgeschaltet werden. Somit führen Fehler in der Signalübertragung nicht zu einem ungewollten Abschalten der Halbleiter 1 der Halbleiterschaltung 5. Mit diesem Lebendsignal 12 ist eine Reaktionszeit Δt₂ von ca. 200ns realisierbar. Damit kann die Halbleiterschaltung 5 oder ein Stromrichter 20 zuverlässig vor hohen Strömen, die im Fehlerfall entstehen können, geschützt werden, indem die Halbleiter mit nur geringem Zeitverzug abgeschaltet werden.

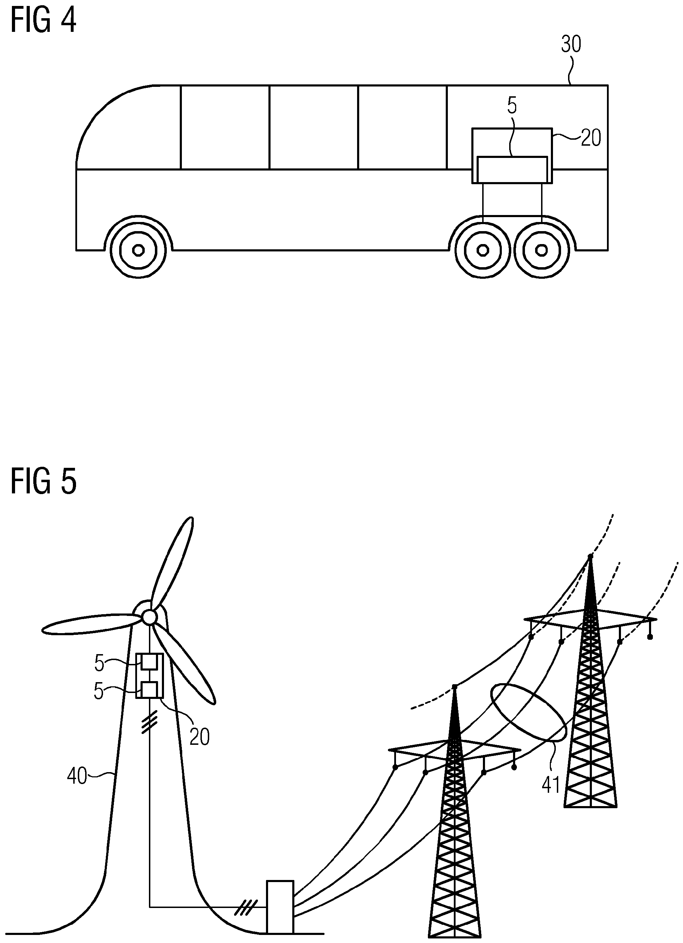

Die FIG 4 zeigt ein Fahrzeug 30, in diesem Beispiel einen Bus, allerdings könnte es sich auch beispielsweise um einen Personenkraftwagen, Lastwagen oder ein Schienenfahrzeug handeln. Dieses Fahrzeug 30 weist einen Stromrichter 20 mit einer zuvor beschriebenen Halbleiterschaltung 5 auf. Der Stromrichter 20 versorgt dabei die Motoren des Fahrzeugs 30 und kann die Beschleunigung bzw. Verzögerung des Fahrzeugs 30 steuern bzw. regeln. Gerade für ein Fahrzeug 30 ist es aus Sicherheitsgründen erforderlich, dass ein Abschalten der Halbleiter 1 schnell und vor allem zuverlässig erfolgt. Eine Beschädigung des Stromrichters 20 aufgrund zu großen Strömen im Fehlerfall muss vermieden werden, damit eine hohe Zuverlässigkeit und Verfügbarkeit des Fahrzeugs 30 erreicht werden und ein Liegenbleiben des Fahrzeugs 30 vermieden werden kann.

Die FIG 5 zeigt eine Windenergieanlage 40 zur Gewinnung von elektrischer Energie aus Wind. Diese Energie wird über Rotorblätter dem Wind entnommen und über einen Stromrichter 20 mit einer oder mehreren Halbleiterschaltungen 5 derart umgewandelt, dass diese in ein Energieversorgungsnetz 41 eingespeist werden kann. Um auch hier einen zuverlässigen Betrieb des Stromrichters 20 sicherzustellen, hat es sich als vorteilhaft erwiesen, diese Windkraftanlage 40 mit einer zuvor beschriebenen Halbleiterschaltung 5 auszustatten. Diese gewährleistet ein schnelles Abschalten der hier nicht näher dargestellten Halbleiter 1 und vermeidet insbesondere im Fehlerfall Beschädigungen oder Zerstörung der Halbleiter 1 durch zu große Ströme.

Zusammenfassend betrifft die Erfindung ein Verfahren zum Ansteuern einer Vielzahl von Halbleitern durch eine Regelungseinheit, wobei zwischen der Regelungseinheit und den Halbleitern eine Signalleitung angeordnet ist, wobei über die Signalleitung ein Protokoll zur Ansteuerung der Halbleiter übertragen wird. Zur Verbesserung der Übertragung von Signalen von der Regelungseinheit zum Stromrichter hinsichtlich der Übertragungssicherheit wird vorgeschlagen, dass über die Signalleitung zusätzlich ein Lebendsignal übertragen wird, wobei bei Ausbleiben des Lebendsignals die Halbleiter abgeschaltet werden. Weiter betrifft die Erfindung eine Halbleiterschaltung, aufweisend eine Vielzahl von Halbleitern mit jeweils einer Treiberschaltung und eine Regelungseinheit, wobei zwischen der Regelungseinheit und den Halbleitern eine Signalleitung angeordnet ist, wobei über die Signalleitung ein Protokoll zur Ansteuerung der Halbleiter übertragbar ist, wobei über die Signalleitung zusätzlich ein Lebendsignal übertragbar ist, wobei bei Ausbleiben des Lebendsignals die Halbleiter mittels der jeweiligen Treiberschaltung abschaltbar sind. Die Erfindung betrifft ferner einen Stromrichter mit einer derartigen Halbleiterschaltung, wobei die Halbleiter oder zumindest ein Teil der Halbleiter in einer Brückenschaltung angeordnet sind. Die Erfindung betrifft weiter ein Fahrzeug sowie eine Windenergieanlage mit einem derartigen Stromrichter.

## Patentansprüche

1. Verfahren zum Ansteuern einer Vielzahl von Halbleitern (1) durch eine Regelungseinheit (2), wobei zwischen der Regelungseinheit (2) und den Halbleitern (1) eine Signalleitung (3) angeordnet ist, wobei über die Signalleitung (3) ein Protokoll (11) zur Ansteuerung der Halbleiter (1) übertragen wird, **dadurch gekennzeichnet, dass** über die Signalleitung (3) zusätzlich ein Lebendsignal (12) übertragen wird, wobei bei Ausbleiben des Lebendsignals (12) die Halbleiter (1) abgeschaltet werden.

2. Verfahren nach Anspruch 1, wobei das Lebendsignal (12) zyklisch oder dauerhaft übertragen wird.

3. Verfahren nach einem der Ansprüche 1 oder 2, wobei das Lebendsignal (12) als Manchester Code übertragen wird.

4. Verfahren nach einem der Ansprüche 1 bis 3, wobei die Signalleitung (3) als Lichtwellenleiter oder Bussystem ausgebildet ist.

5. Halbleiterschaltung (5), aufweisend
- eine Vielzahl von Halbleitern (1) mit jeweils einer Treiberschaltung (4) und
- eine Regelungseinheit (2),
wobei zwischen der Regelungseinheit (2) und den Halbleitern (1) eine Signalleitung (3) angeordnet ist, wobei über die Signalleitung (3) ein Protokoll (11) zur Ansteuerung der Halbleiter (1) übertragbar ist, **dadurch gekennzeichnet, dass** über die Signalleitung (3) zusätzlich ein Lebendsignal (12) übertragbar ist, wobei bei Ausbleiben des Lebendsignals (12) die Halbleiter (1) mittels der jeweiligen Treiberschaltung (4) abschaltbar sind.

6. Halbleiterschaltung (5) nach Anspruch 5, wobei die Signalleitung (3) als Lichtwellenleiter oder Bussystem ausgebildet ist.

7. Stromrichter (20) mit einer Halbleiterschaltung (5) nach einem der Ansprüche 5 oder 6, wobei die Halbleiter (1) oder zumindest ein Teil der Halbleiter (1) in einer Brückenschaltung angeordnet sind.

8. Fahrzeug (30) mit einem Stromrichter (20) nach Anspruch 7.

9. Windenergieanlage (40) mit einem Stromrichter (20) nach Anspruch 7.
